(19)

Europäisches
Patentamt
European
Patent Office
Office européen
des brevets

(11) **EP 3 348 537 A1**

(12) **EUROPEAN PATENT APPLICATION**
published in accordance with Art. 153(4) EPC

(43) Date of publication:
**18.07.2018 Bulletin 2018/29**

(21) Application number: **16844119.4**

(22) Date of filing: **15.08.2016**

(51) Int Cl.:
*C04B 37/02* (2006.01)      *B22F 1/00* (2006.01)
*B22F 7/04* (2006.01)       *B22F 9/00* (2006.01)
*C09J 1/00* (2006.01)       *C09J 11/00* (2006.01)
*C09J 133/00* (2006.01)     *C09J 183/04* (2006.01)
*C09J 201/00* (2006.01)     *B22F 1/02* (2006.01)

(86) International application number:
**PCT/JP2016/073821**

(87) International publication number:
**WO 2017/043256 (16.03.2017 Gazette 2017/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **09.09.2015 JP 2015177616**

(71) Applicant: **Mitsubishi Materials Corporation
Chiyoda-ku
Tokyo 100-8117 (JP)**

(72) Inventors:
• **MASUYAMA Kotaro**
 **Naka-shi**
 **Ibaraki 311-0102 (JP)**
• **YAMASAKI Kazuhiko**
 **Naka-shi**
 **Ibaraki 311-0102 (JP)**

(74) Representative: **Gille Hrabal
Brucknerstrasse 20
40593 Düsseldorf (DE)**

(54) **COMPOSITION AND METHOD FOR MANUFACTURING BONDED BODY**

(57)      Selected is a composition containing a silver powder generating gaseous carbon dioxide, acetone vapor, and water vapor in a case where the silver powder is heated at 100°C, a stress relaxation body having a Young's modulus lower than a Young's modulus of a sintered body of the silver powder, and a solvent, in which a particle size distribution of primary particles of the silver powder has a first peak in a range of a particle size of 20 to 70 nm and a second peak in a range of a particle size of 200 to 500 nm, an organic substance in the silver powder is decomposed by 50% by mass or more at 150°C, and a mass ratio between the silver powder and the stress relaxation body is 99:1 to 60:40.

**EP 3 348 537 A1**

## Description

Technical Field

The present invention relates to a composition and a method of producing a bonded body.
Priority is claimed on Japanese Patent Application No. 2015-177616, filed on September 9, 2015, the content of which is incorporated herein by reference.

Background Art

In a case where two or more parts are bonded to each other at the time of assembling or mounting electronic parts, generally, a bonding material is used. As such a bonding material, a paste-like bonding material is known which is obtained by dispersing metal particles such as silver powder in a solvent. At the time of bonding the parts to each other by using the bonding material, by coating a surface of one of the parts with the bonding material, bringing the coated surface into contact with the other part, and heating the parts in this state, the parts can be bonded to each other.
For example, PTL 1 discloses, as a bonding material for reducing the unevenness of shear strength while securing shear strength, a bonding material containing submicron-sized metal particles having an average primary particle size of 0.5 to 3.0 $\mu$m, nanosized metal particles having an average primary particle size of 1 to 200 nm, and a dispersion medium.

Citation List

Patent Literature

[PTL 1] Japanese Unexamined Patent Application, First Publication No. 2011-80147

Summary of Invention

Technical Problem

Unfortunately, in a case where a bonding layer is formed using the bonding material disclosed in PTL 1, the bonding layer deteriorates due to the internal stress of the bonding layer caused by the temperature change, and hence the durability or the reliability is reduced.
The present invention has been made under the circumstances described above, and an object thereof is to provide a composition, which makes it possible to form a bonding layer having excellent heating-cooling cycle resistance, and a method of producing a bonded body using the composition.

Solution to Problem

In order to achieve the aforementioned object, the present invention adopts the following constitution.

(1) A composition including a silver powder generating gaseous carbon dioxide, acetone vapor, and water vapor in a case where the silver powder is heated at 100°C, a stress relaxation body having a Young's modulus lower than a Young's modulus of a sintered body of the silver powder, and a solvent, in which a particle size distribution of primary particles of the silver powder has a first peak in a range of a particle size of 20 to 70 nm and a second peak in a range of a particle size of 200 to 500 nm, an organic substance in the silver powder is decomposed by 50% by mass or more at 150°C, and a mass ratio between the silver powder and the stress relaxation body is 99:1 to 60:40.
(2) The composition described in (1), in which a Young's modulus of the stress relaxation body is 3 GPa or less.
(3) The composition described in (1) or (2), in which the stress relaxation body has a spherical shape.
(4) The composition described in any one of (1) to (3), in which a material of the stress relaxation body is an acrylic resin or a silicone resin.
(5) A method of producing a bonded body in which a first member and a second member are bonded to each other through a bonding layer, the method including the step of forming the bonding layer by using the composition described in any one of (1) to (4).

Advantageous Effects of Invention

The composition as an aspect of the present invention (hereinafter, referred to as "composition of the present invention") contains a silver powder generating gaseous carbon dioxide, acetone vapor, and water vapor in a case where the silver powder is heated at 100°C, a stress relaxation body having a Young's modulus lower than that of a sintered body of the silver powder, and a solvent, in which a particle size distribution of primary particles of the silver powder has a first peak in a range of a particle size of 20 to 70 nm and a second peak in a range of a particle size of 200 to 500 nm, an organic substance in the silver powder is decomposed by 50% by mass or more at 150°C, and a mass ratio between the silver powder and the stress relaxation body is 99:1 to 60:40. Therefore, with the composition, a bonding layer having excellent heating-cooling cycle resistance can be formed.

In the method of producing a bonded body as another aspect of the present invention (hereinafter, referred to as "bonded body manufacturing method of the present invention"), the aforementioned composition is used. Therefore, a bonded body having excellent heating-cooling cycle resistance can be manufactured.

Brief Description of Drawings

FIG. 1 is a view for illustrating a method of producing a composition as an embodiment to which the present invention is applied.

FIG. 2 is a view for illustrating the method of producing the composition as the embodiment to which the present invention is applied.

FIG. 3 is a schematic cross-sectional view of a bonded body as an embodiment to which the present invention is applied.

Description of Embodiments

Hereinafter, a composition and a method of producing a bonded body as embodiments to which the present invention is applied will be specifically described. In the drawings used for the following description, for convenience, characteristic portions are enlarged in some cases such that the characteristics are understood better, and the dimensional ratio between constituents and the like are not exactly the same as the actual dimensional ratio and the like.

<Composition>

First, the constitution of a composition as an embodiment to which the present invention is applied will be described. The composition of the present embodiment is roughly constituted with silver powder, a stress relaxation body having a Young's modulus lower than that of a sintered body of the silver powder, and a solvent. The silver powder is constituted with pure silver and a silver alloy containing silver as a main component (the silver content is equal to or greater than 99% by mass).

By being subjected to a heating treatment, the composition of the present embodiment can form a bonding layer and can bond two or more adjacent objects to each other which are to be bonded to each other.

The shape of the silver powder is not particularly limited, and specific examples thereof include a spherical shape, a rod shape, a scale shape, and the like.

For determining the particle size, 1,000 or more primary particles were observed using a scanning electron microscope, and by using image processing software "Image J (developed by National Institutes of Health), binarization processing was performed on the SEM image such that the boundary between a particle and a region other than the particle was determined. Then, the area of each of the particles was calculated from the number of pixels and converted into the area of a perfect circle, thereby determining a primary particle size of each of the particles. The largest two particle sizes that were most frequently found were calculated. Between these, the smaller one was defined as a particle size of a first peak, and the larger one was defined as a particle size of a second peak.

The silver powder has a particle size distribution within a predetermined range. Specifically, the particle size distribution of the primary particles of the silver powder has a first peak in a range of a particle size of 20 to 70 nm and preferably in a range of a particle size of 30 to 50 nm and has a second peak in a range of a particle size of 200 to 500 nm and preferably in a range of a particle size of 300 to 400 nm, for example.

In a case where the first peak is equal to or greater than 20 nm, at the time of heating treatment, a bonding layer thick enough to maintain bonding can be formed. In a case where the first peak is equal to or smaller than 70 nm, a degree of filling of silver into the bonding layer can be increased.

In a case where the second peak is equal to or greater than 200 nm, at the time of heating treatment, a bonding layer thick enough to maintain bonding can be formed. In a case where the second peak is equal to or smaller than 500 nm, a degree of filling of silver into the bonding layer can be increased.

Furthermore, in a case where the particle size distribution of the primary particles is within the aforementioned range, after a surface of the object to be bonded is coated with the composition, a degree of filling of silver powder into the composition can be increased. Accordingly, at the time of heating treatment, the silver powder can be uniformly and sufficiently sintered in the bonding layer. As a result, a degree of filling of silver into the formed bonding layer can be increased, and the heating-cooling cycle resistance is improved.

The particle size distribution can be measured by, for example, observing the silver powder by using a commercial scanning electron microscope (SEM, for example, "S-4300SE" manufactured by Hitachi High-Technologies Corporation, and the like) and measuring particle sizes of 1,000 or more silver particles. At this time, the largest two particle sizes that are most frequently found are calculated. Between these, the smaller one is defined as a particle size of a first peak, and the larger one is defined as a particle size of a second peak.

The silver powder is coated with an organic substance. Specifically, as the organic substance with which the silver powder is coated, for example, an organic substance decomposed by 50% by mass or more at 150°C is preferable, and an organic substance decomposed by 75% by mass or more at 150°C is more preferable.

The decomposition rate of the organic substance with which the silver powder is coated is defined as a decomposition rate of the organic substance obtained after the silver powder is treated for 30 minutes at 150°C.

In a case where the organic substance with which the silver powder is coated is decomposed by 50% by mass or more at 150°C, the silver powder is easily sintered, and the heating-cooling cycle resistance of the bonding layer is improved.

The decomposition rate of the organic substance with which the silver powder is coated can be measured by, for example, keeping the silver powder in the atmosphere for a predetermined period of time at a predetermined temperature and then measuring a decrease in mass after heating compared to the mass before heating.

By being heated, the silver powder generates gas. Specifically, in a case where the silver powder in a powder state is heated at 100°C, gaseous carbon dioxide, acetone vapor, water vapor, and the like are generated.

The aforementioned gas is derived from organic molecules adsorbed onto the surface of the silver powder. The lower the molecular weight of the organic molecules, the easier it is for the organic molecules to be separated and released from the surface of the silver powder by heating. Therefore, the silver powder generating the gas is easily sintered, and the heating-cooling cycle resistance of the bonding layer is improved.

The gas generated at the time of heating the silver powder can be identified by, for example, analyzing the gas by using a commercial pyrolysis gas chromatograph-mass spectrometer (pyrolysis GC/MS, GC/MS in which a pyrolyser is installed in a portion from which silver powder is introduced, for example, "PY-3030" manufactured by Frontier Laboratories Ltd., "JMS-T100GCV" manufactured by JEOL Ltd., or the like).

Because a degree of sintering in the film varies with the synthesis conditions of the silver powder used and the heating conditions of the composition, a preset value cannot be mentioned as the Young's modulus of the sintered body of the silver powder. However, specifically, in a case where the silver powder is heated at 150°C for 30 minutes, for example, the sintered body of the silver powder has a Young's modulus of higher than 15 GPa and equal to or lower than 25 GPa.

The stress relaxation body has a Young's modulus lower than that of the aforementioned sintered body of the silver powder. Specifically, the Young's modulus of the stress relaxation body is preferably is 3 GPa or less, for example. Provided that the Young's modulus of the stress relaxation body is 3 GPa or less which is a sufficiently low value, in a case where stress occurs due to the thermal expansion and shrinkage of the sintered body of the silver powder, the stress relaxation body can be flexibly deformed. Presumably, for this reason, breaking of the bonding layer may be inhibited, and an excellent stress relieving effect can be obtained at a Young's modulus of is 3 GPa or less.

In a case where the Young's modulus of the stress relaxation body is lower than that of the sintered body of the silver powder, specifically, lower than 3 GPa, the bonding layer formed using the composition can sufficiently obtain the stress relieving effect by the deformation of the stress relaxation body. Accordingly, the heating-cooling cycle resistance of the bonding layer is improved.

The Young's modulus of the sintered body of the silver powder and the stress relaxation body can be measured using, for example, a microcompression testing machine (for example, "MCT-2000" manufactured by Shimadzu Corporation or the like).

The stress relaxation body has a coefficient of thermal expansion within a predetermined range. Specifically, the coefficient of thermal expansion of the stress relaxation body is preferably equal to or smaller than $7 \times 10^{-5}$/K, for example.

In a case where the coefficient of thermal expansion of the stress relaxation body is $7 \times 10^{-5}$/K or less, at the time of heating the bonding layer formed of the composition, it is possible to prevent the internal structure of the bonding layer from breaking. Therefore, the heating-cooling cycle resistance of the bonding layer is improved.

The method for measuring the coefficient of thermal expansion of the stress relaxation body is not particularly limited, and examples thereof include a method based on JIS K7197 or the like.

The shape of the stress relaxation body is not particularly limited, and specific examples thereof include a spherical shape, a plate shape, a rod shape, a fiber shape, and the like.

The material of the stress relaxation body is not particularly limited, and specific examples thereof include an acrylic resin, a silicone resin, heat-resisting rubber, cellulose, and the like. Among stress relaxation bodies (mainly organic substances) having elasticity, in a case where a material having high heat resistance is used as the material of the stress relaxation body, the deterioration of the bonding layer can be inhibited.

The composition of the present embodiment may include one kind of stress relaxation body having the aforementioned shape and material or two or more kinds of such stress relaxation bodies.

The solvent is not particularly limited, and specific examples thereof include an alcohol-based solvent, a glycol-based solvent, an acetate-based solvent, a hydrocarbon-based solvent, an amine-based solvent, and the like.

The alcohol-based solvent is not particularly limited, and specific examples thereof include α-terpineol, isopropyl alcohol, and the like.

The glycol-based solvent is not particularly limited, and specific examples thereof include ethylene glycol, diethylene glycol, polyethylene glycol, and the like.

The acetate-based solvent is not particularly limited, and specific examples thereof include butyl carbitol acetate and the like.

The hydrocarbon-based solvent is not particularly limited, and specific examples thereof include decane, dodecane, tetradecane, and the like.

The amine-based solvent is not particularly limited, and specific examples thereof include hexylamine, octylamine, dodecylamine, and the like.

One kind of the solvent described above may be used singly, or two or more kinds of the solvents described above may be used by being mixed together.

The composition of the present embodiment is in the form of a paste because the composition is formed by mixing the silver powder, the stress relaxation body, and the solvent described above together. Therefore, the surfaces of an object to be bonded can be coated with the composition.

Specifically, the mass ratio between the silver powder and the stress relaxation body (silver powder:stress relaxation body) contained in the composition is, for example, preferably 99:1 to 60:40, and more preferably 95:5 to 70:30.

In a case where the proportion of the silver powder contained in the composition is higher than the upper limit described above, a durability improving effect cannot be sufficiently obtained. In a case where the proportion of the silver powder is less than the lower limit described above, a bonding strength improving effect resulting from sintering of the silver powder cannot be sufficiently obtained.

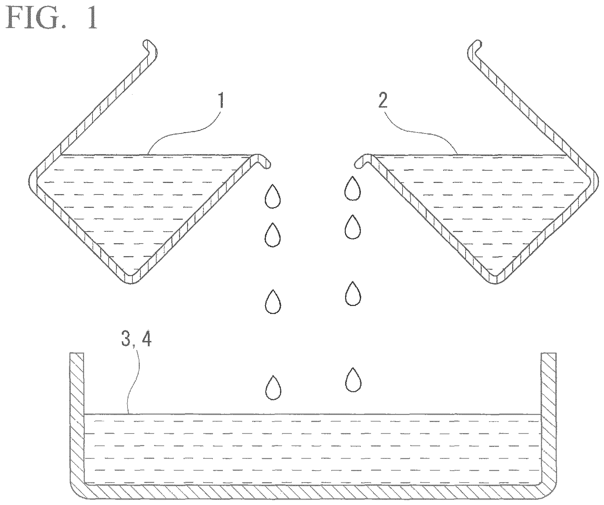

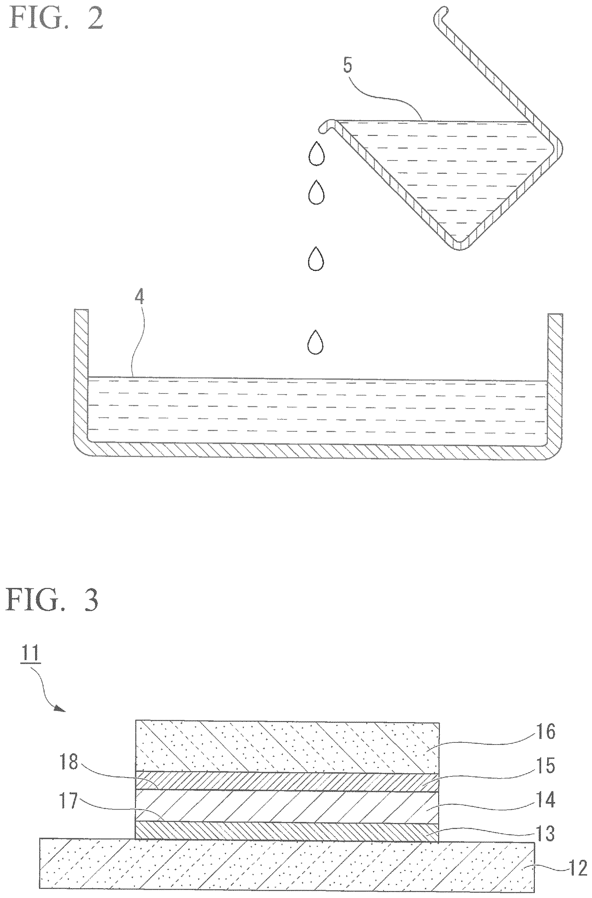

Next, a method of producing the aforementioned composition will be described with reference to FIGS. 1 and 2.

First, as shown in FIG. 1, an aqueous silver salt solution 1 and an aqueous carboxylate solution 2 are simultaneously added dropwise to water 3, thereby preparing a silver carboxylate slurry 4.

At the time of preparing the silver carboxylate slurry 4, it is preferable that the temperature of each of the solutions 1 to 4 is kept at a predetermined temperature in a range of 20°C to 90°C. In a case where the temperature of each of the solutions 1 to 4 is kept at a predetermined temperature equal to or higher than 20°C, silver carboxylate is easily generated, and the particle size of the silver powder can be increased. Furthermore, in a case where the temperature of each of the solutions 1 to 4 is kept at a predetermined temperature equal to or lower than 90°C, it is possible to prevent the silver powder from becoming coarse particles.

It is preferable that while the aqueous silver salt solution 1 and the aqueous carboxylate solution 2 are being added dropwise to the water 3, the water 3 is stirred.

Specifically, as the silver salt in the aqueous silver salt solution 1, for example, one kind of compound or two or more kinds of compounds selected from the group consisting of silver nitrate, silver chlorate, silver phosphate, and salts of these are preferable.

As the carboxylic acid in the aqueous carboxylate solution 2, one kind of compound or two or more kinds of compounds selected from the group consisting of glycolic acid, citric acid, malic acid, maleic acid, malonic acid, fumaric acid, succinic acid, tartaric acid, and salts of these are preferable.

Examples of the water 3 include deionized water, distilled water, and the like. It is particularly preferable to use deionized water, because deionized water does not contain ions which may negatively affect the synthesis and the manufacturing cost of deionized water is lower than that of distilled water.

Thereafter, as shown in FIG. 2, an aqueous reductant solution 5 is added dropwise to the silver carboxylate slurry 4, and then the slurry is subjected to a predetermined heat treatment, thereby preparing a silver powder slurry.

Specifically, for example, the predetermined heat treatment may be a heat treatment in which the slurry is heated to a predetermined temperature (maximum temperature) in a range of 20°C to 90°C at a heating rate equal to or lower than 15°C/hour in water, kept at the maximum temperature for 1 to 5 hours, and then cooled down to a temperature equal to or lower than 30°C for a period of time equal to or shorter than 30 minutes.

In the aforementioned predetermined heat treatment, by setting the heating rate to be 15°C/hour or less, it is possible to prevent the silver powder from becoming coarse particles.

Furthermore, in the aforementioned predetermined heat treatment, by setting the maximum temperature to be equal to or higher than 20°C, the silver carboxylate is easily reduced, and the particle size of the silver powder can be increased. In addition, by setting the maximum temperature to be 90°C or less, it is possible to prevent the silver powder from becoming coarse particles.

In the aforementioned predetermined heat treatment, by setting the retention time at the maximum temperature to be 1 hour or longer, the silver carboxylate is easily reduced, and the particle size of the silver powder can be increased. Furthermore, by setting the retention at the maximum temperature to be 5 hours or shorter, it is possible to prevent the silver powder from becoming coarse particles.

In the aforementioned predetermined heat treatment, by cooling the slurry down to 30°C within a period of time equal to or shorter than 30 minutes, it is possible to prevent the silver powder from becoming coarse particles.

At the time of preparing the silver powder slurry, it is preferable that the temperature of each of the solutions 4 and 5 is kept at a predetermined temperature in a range of 20°C to 90°C. In a case where the temperature of each of the solutions 4 and 5 is kept at a predetermined temperature equal to or higher than 20°C, the silver carboxylate is easily reduced, and the particle size of the silver powder can be increased. In a case where the temperature of each of the solutions 4 and 5 is kept at a predetermined temperature equal to or lower than 90°C, it is possible to prevent the silver powder from becoming coarse particles.

As the reductant in the aqueous reductant solution 5, one kind of compound or two or more kinds of compounds selected from the group consisting of hydrazine, ascorbic acid, oxalic acid, formic acid, and salts of these are preferable.

Subsequently, by drying the silver powder slurry, silver powder is obtained. Before the silver powder slurry is dried, it is preferable to remove a liquid layer from the silver powder slurry by using a centrifuge such that the silver powder slurry is dehydrated and desalted.

The method for drying the silver powder slurry is not particularly limited, and specific examples thereof include a freeze drying method, a decompression drying method, a heat drying method, and the like. The freeze drying method is a method of freezing the silver powder slurry by putting the slurry into an airtight container, reducing the boiling point of the object to be dried by reducing the internal pressure of the airtight container by using a vacuum pump, and sublimating the moisture of the object to be dried at a low temperature such that the object is dried. The decompression drying method is a method of drying the object to be dried by decompression. The heat drying method is a method of drying the object to be dried by heating.

Thereafter, by mixing the generated silver powder, a stress relaxation body, and a solvent together, a composition is manufactured. Specifically, a mass ratio between the silver powder and the stress relaxation body (silver powder:stress relaxation body) contained in the composition is, for example, preferably 99:1 to 60:40, and more preferably 95:5 to 70:30.

<Bonded body>

Next, the constitution of a bonded body as an embodiment to which the present invention is applied will be described with reference to FIG. 3. FIG. 3 shows a bonded body 11 of the present embodiment. As shown in FIG. 3, the bonded body 11 of the present embodiment is roughly constituted with a substrate 12, a first metal layer 13, a bonding layer 14, a second metal layer 15, and an object 16 to be bonded.

In the present embodiment, for example, the bonded body 11 obtained by bonding the substrate 12 (first member) and the object 16 to be bonded (second member) together by using the aforementioned composition will be described, but the objects to be bonded together by using the composition are not particularly limited.

The substrate 12 is not particularly limited, and specific examples thereof include an aluminum plate, an insulating substrate to which an aluminum plate is bonded, and the like.

The first metal layer 13 is laminated on the substrate 12 in a state of being adjacent to the substrate 12. Through the first metal layer 13, the substrate 12 and the bonding layer 14 are bonded to each other. Specifically, as the material of the first metal layer 13, for example, it is possible to use one kind of metal or two or more kinds of metals selected from the group consisting of gold, silver, copper, and the like.

The bonding layer 14 is laminated between the first metal layer 13 and the second metal layer 15 in a state of being adjacent to these metal layers.

By coming into contact with the first metal layer 13, the bonding layer 14 forms an interface 17. Furthermore, by coming into contact with the second metal layer 15, the bonding layer 14 forms an interface 18. The bonding layer 14 is formed by coating the first metal layer 13 with the aforementioned composition, placing the object 16 to be bonded such that the coated surface and the second metal layer 15 face each other, and performing a heating treatment.

In the bonding layer 14, a stress relaxation body having a Young's modulus lower than that of silver is dispersed. In a case where a cross-sectional view of the bonding layer 14 is observed, an area ratio of the stress relaxation body is in a range of equal to or higher than 5% and equal to or lower than 90%.

The thickness of the bonding layer 14 is not particularly limited as long as the substrate 12 and the object 16 to be bonded can be bonded to each other. Specifically, the thickness of the bonding layer 14 is 1 to 100 $\mu$m, for example.

The second metal layer 15 is laminated on the bonding layer 14, in a state of being adjacent to a side opposite to the first metal layer 13. Through the second metal layer 15, the bonding layer 14 and the object 16 to be bonded are bonded to each other.

As the material of the second metal layer 15, it is possible to use the same material as the material used in the first metal layer 13.

The object 16 to be bonded is laminated on the second metal layer 15, in a state of being adjacent to a side opposite to the bonding layer 14. The object 16 to be bonded is not particularly limited, and specific examples thereof include silicon (Si), silicon carbide (SiC), and the like. In the bonded body 11 of the present embodiment, the aforementioned composition is used. Therefore, a material vulnerable to heat can also be used as the object 16 to be bonded.

In the bonded body 11 of the present embodiment, the substrate 12 and the object 16 to be bonded are bonded to each other by the bonding layer 14. The bonding layer 14 is formed using the aforementioned composition. Therefore, the heating-cooling cycle resistance of the bonding layer 14 is excellent.

The heating-cooling cycle resistance is evaluated as below, for example. The bonded body 11 is put into a heating-cooling cycle testing device. Thereafter, the internal temperature of the device is decreased to -40°C from 25°C and kept as it is for 10 minutes, then increased to 180°C and kept as it is for 20 minutes, and then decreased to 25°C. This process is regarded as one cycle, and the heating-cooling cycle resistance can be evaluated using a bonding rate obtained after 3,000 cycles. The bonding rate can be calculated by Equation (1).

$$\text{(Bonding rate)} = \{\text{(initial bonding area)} - \text{(peeling area)}\}/\text{(initial bonding area)} \times 100 \quad (1)$$

The initial bonding area is an area to be bonded that is determined before bonding, in other words, the area of an object to be bonded (silicon chip or the like) that is bonded. In an ultrasonic inspection image, peeling is seen as a white portion in the bonding portion. Therefore, the area of the white portion is regarded as the peeling area. The area of the white portion can be determined by performing binarization processing by using image processing software "Image J (developed by National Institutes of Health) and converting the number of pixels in the white portion into the area.

Next, a method of producing the aforementioned bonded body 11 will be described by using FIG. 3.

First, on a surface of the substrate 12, a metal is laminated by a known method, thereby laminating the first metal layer 13. In the same manner, on a surface of the object 16 to be bonded, the second metal layer 15 is laminated.

The method for laminating a metal on the surfaces of the substrate 12 and the object 16 to be bonded is not particularly limited, and specific examples thereof include a vacuum vapor deposition method, a sputtering method, a plating method, a printing method, and the like.

Then, a surface of the first metal layer 13 is coated with the composition of the embodiment described above by a known method. The method for coating the surface of the first metal layer 13 with the composition is not particularly limited, and specific examples thereof include a spin coating method, a metal mask method, a screen printing method, and the like.

Subsequently, on the composition with which the surface of the first metal layer 13 is coated, the object 16 to be bonded is placed such that the second metal layer 15 side faces the object 16. Thereafter, by performing a heating treatment, the bonding layer 14 is formed of the composition, and the bonding layer 14, the first metal layer 13, and the second metal layer 15 are bonded to each other.

The heating temperature at the time of heating treatment is not particularly limited. Specifically, the heating temperature is preferably equal to or higher than 150°C, for example. In a case where the heating temperature is equal to or higher than 150°C, the shear strength of the bonding layer 14 can be increased.

The heating time at the time of heating treatment is not particularly limited. Specifically, the heating time is preferably equal to or longer than 30 minutes, for example. In a case where the heating time is equal to or longer than 30 minutes, the shear strength of the bonding layer 14 can be increased.

Through the steps described above, the bonded body 11 is manufactured.

As described above, the composition of the present embodiment contains a silver powder generating gaseous carbon dioxide, acetone vapor, and water vapor in a case where the silver powder is heated at 100°C, a stress relaxation body having a Young's modulus lower than that of a sintered body of the silver powder, and a solvent, in which a particle size distribution of primary particles of the silver powder has a first peak in a range of a particle size of 20 to 70 nm and a second peak in a range of a particle size of 200 to 500 nm, an organic substance in the silver powder is decomposed by 50% by mass or more at 150°C, and a mass ratio between the silver powder and the stress relaxation body is 99:1 to 60:40. Therefore, a bonding layer having excellent heating-cooling cycle resistance can be formed.

Furthermore, in the present embodiment, the stress relaxation body has a Young's modulus is 3 GPa or less and a coefficient of thermal expansion equal to or lower than $7 \times 10^{-5}$/K. Therefore, a bonding layer having excellent heating-cooling cycle resistance can be reliably formed.

In the bonded body 11 of the present embodiment, the stress relaxation body having a Young's modulus lower than that of silver is dispersed. Furthermore, in a case where a cross-sectional view of the bonding layer 14 is observed, an area ratio of the stress relaxation body is in a range of equal to or higher than 5% and equal to or lower than 90%. Therefore, the heating-cooling cycle resistance is excellent.

According to the method of producing a bonded body of the present embodiment, a bonded body is formed using the composition of the present embodiment. Therefore, a bonded body having excellent heating-cooling cycle resistance can be manufactured.

Hitherto, the embodiment of the present invention has been specifically described with reference to drawings. However, the specific constitution is not limited to the embodiment and includes design and the like which are within a scope that does not depart from the gist of the present invention. For example, in the above section, for example, the bonded body 11 including the first metal layer 13 and the second metal layer 15 was described, but the present invention is not limited thereto. For example, the bonded body 11 may not include either or both of the first metal layer 13 and the second metal layer 15.

Examples

Hereinafter, the effects of the present invention will be specifically described using examples and comparative examples, but the present invention is not limited to the following examples.

<Synthesis of silver powder>

(Type I)

First, as shown in FIG. 1, 900 g of an aqueous silver nitrate solution (aqueous silver salt solution 1) kept at 50°C and 600 g of an aqueous ammonium citrate solution (aqueous carboxylate solution 2) kept at 50°C were simultaneously added dropwise for 5 minutes to 1,200 g of deionized water (water 3) kept at 50°C, thereby preparing a silver citrate slurry (silver carboxylate slurry 4).

While the aqueous silver nitrate solution (aqueous silver salt solution 1) and the aqueous ammonium citrate solution (aqueous carboxylate solution 2) were being simultaneously added dropwise to the deionized water (water 3), the deionized water (water 3) was continuously stirred. The concentration of silver nitrate in the aqueous silver nitrate solution (aqueous silver salt solution 1) was 66% by mass, and the concentration of citric acid in the aqueous ammonium citrate solution (aqueous carboxylate solution 2) was 56% by mass.

Then, as shown in FIG. 2, 300 g of an aqueous ammonium formate solution (aqueous reductant solution 5) kept at 50°C was added dropwise for 30 minutes to the silver citrate slurry (silver carboxylate slurry 4) kept at 50°C, thereby obtaining a mixed slurry. The concentration of formic acid in the aqueous ammonium formate solution (aqueous reductant solution 5) was 58% by mass.

Subsequently, a predetermined heat treatment was performed on the mixed slurry. Specifically, the mixed slurry was heated to a maximum temperature of 70°C at a heating rate of 10°C/hour, kept at 70°C (maximum temperature) for 2 hours, and then cooled down to 30°C for 60 minutes. In this way, a silver powder slurry was obtained. The silver powder slurry was put into a centrifuge and rotated for 10 minutes at a rotation speed of 1,000 rpm. In this way, a liquid layer was removed from the silver powder slurry, and a dehydrated and desalted silver powder slurry was obtained.

The dehydrated and desalted silver powder slurry was dried for 30 minutes by a freeze drying method, thereby obtaining type I silver powder.

(Type II)

Type II silver powder was obtained by the same method as that for type I, except that a mixed slurry was prepared while keeping the temperature of each of the solutions at 80°C, and the maximum temperature at the time of heat treatment was 80°C.

(Type III)

Type III silver powder was obtained by the same method as that for type I, except that a mixed slurry was prepared while keeping the temperature of each of the solutions at 30°C, the heating rate at the time of heat treatment was 0°C/hour, the maximum temperature was 30°C, and the retention time was 5 hours.

(Type IV)

Type IV silver powder was obtained by the same method as that for type I, except that a mixed slurry was prepared while keeping the temperature of each of the solutions at 15°C, the heating rate at the time of heat treatment was 0°C/hour, the maximum temperature was 15°C, and the retention time was 5 hours.

(Type V)

Type V silver powder was obtained by the same method as that for type I, except that the retention time at the time of heat treatment was 8 hours.

(Type VI)

As type VI silver powder, commercial silver powder ("SPQ03S" manufactured by MITSUI MINING & SMELTING CO., LTD) was prepared.

<Evaluation of silver powder>

The particle size distribution of primary particles of type I to type VI silver powder, the decomposition rate of the organic substance, with which the silver powder was coated, at a predetermined temperature (decomposition rate of the organic substance), and the type of gas generated from the organic substance, with which the silver powder was coated, in a case where the silver powder in a powder state was heated (type of gas generated by heating) were measured.
The particle size distribution of primary particles of the silver powder was measured by observing the silver powder by using SEM ("S-4300SE" manufactured by Hitachi High-Technologies Corporation) and measuring particle sizes of 1,000 silver particles. At this time, the largest two particle sizes that were most frequently found were calculated. Between these, the smaller one was defined as a particle size of a first peak, and the larger one was defined as a particle size of a second peak.
The decomposition rate of the organic substance was obtained by keeping the silver powder in the atmosphere for 30 minutes at 150°C and then measuring a decrease in mass after heating compared to the mass before heating.
The gas species generated by heating was identified by analyzing the generated gas by using pyrolysis GC/MS ("PY-3030" manufactured by Frontier Laboratories Ltd. and "JMS-T100GCV" manufactured by JEOL Ltd.).
Table 1 shows the measurement results. Table 1 also shows the time for which the aqueous silver nitrate solution and the aqueous ammonium citrate solution were simultaneously added dropwise, the heating rate and the maximum temperature of the silver powder slurry obtained by adding the aqueous ammonium formate solution dropwise to the silver citrate slurry, the temperature at which each solution was kept, and the type of the aqueous reductant solution. Furthermore, in Table 1, among the gas species generated by heating, $CO_2$ is gaseous carbon dioxide, and acetone, water, ethanediol, acetic acid, and pyrrole are vapors of these.

[Table 1]

| Type | Silver powder | | | | | | | | | | |
| --- | --- | --- | --- | --- | --- | --- | --- | --- | --- | --- | --- |
| | Time for dropwise addition (min) | Temperature at which each solution was kept (°C) | Type of aqueous reductant solution | Heat treatment | | | Particle size distribution of primary particles | | Decomposition rate of organic substance (% by mass) | Gas species generated by heating |
| | | | | Heating rate (°C/hour) ) | Maximum temperature (°C) | Retention time (hour) | First peak (nm) | Second peak (nm) | | |
| I | 5 | 50 | Aqueous ammonium formate solution (58% by mass) | 10 | 70 | 2 | 40 | 400 | 80 | $CO_2$, acetone, water |
| II | 5 | 80 | Ditto | 0 | 80 | 2 | 70 | 500 | 70 | $CO_2$, acetone, water |
| III | 5 | 30 | Ditto | 0 | 30 | 5 | 20 | 200 | 50 | $CO_2$, acetone, water |
| IV | 5 | 15 | Ditto | 0 | 15 | 5 | 15 | 150 | 30 | $CO_2$, acetone, water, ethanediol |
| V | 5 | 50 | Ditto | 10 | 70 | 8 | 80 | 550 | 80 | $CO_2$, acetone, water |
| VI | SPQ03S (silver powder manufactured by MITSUI MINING & SMELTING CO., LTD.) | | | | | | - | 750 | 5 | $CO_2$, acetic acid, pyrrole |

<Preparation of composition>

(Example 1)

As a stress relaxation body, a type A stress relaxation body (material: acrylic resin, shape: spherical, average particle size: 10 $\mu$m, Young's modulus: 3 GPa, coefficient of thermal expansion: 7 $\times$ 10$^{-5}$/K) was prepared.
The type I silver powder, the type A stress relaxation body, and ethylene glycol as a solvent were put into a container such that the mass ratio (silver powder:stress relaxation body:solvent) became 80:5:15, and subjected three times to kneading in which the mixture was rotated by a kneader ("AWATORI RENTARO" manufactured by THINKY CORPORATION) for 5 minutes at a rotation speed of 2,000 rpm, thereby obtaining a composition. The mass ratio between the silver powder and the stress relaxation body (silver powder:stress relaxation body) was 94:6.

(Example 2)

A composition was obtained by the same method as that in Example 1, except that the type II silver powder was used. The mass ratio between the silver powder and the stress relaxation body (silver powder:stress relaxation body) was 94:6.

(Example 3)

A composition was obtained by the same method as that in Example 1, except that the type III silver powder was used. The mass ratio between the silver powder and the stress relaxation body (silver powder:stress relaxation body) was 94:6.

(Example 4)

A composition was obtained by the same method as that in Example 1, except that the mass ratio (silver powder:stress relaxation body:solvent) was changed to 84:1:15. The mass ratio between the silver powder and the stress relaxation body (silver powder:stress relaxation body) was 99:1.

(Example 5)

A composition was obtained by the same method as that in Example 1, except that the mass ratio (silver powder:stress relaxation body:solvent) was changed to 50:35:15. The mass ratio between the silver powder and the stress relaxation body (silver powder:stress relaxation body) was 60:40.

(Example 6)

A composition was obtained by the same method as that in Example 1, except that as a stress relaxation body, a type B stress relaxation body (material: silicone resin, shape: spherical, average particle size: 5 $\mu$m, Young's modulus: 0.04 GPa, coefficient of thermal expansion: 8 $\times$ 10$^{-5}$/K) was used. The mass ratio between the silver powder and the stress relaxation body (silver powder:stress relaxation body) was 94:6.

(Example 7)

A composition was obtained by the same method as that in Example 1, except that as a stress relaxation body, a type E stress relaxation body (material: polyimide, shape: spherical, average particle size: 5 $\mu$m, Young's modulus: 4 GPa, coefficient of thermal expansion: 2 $\times$ 10$^{-5}$/K) was used. The mass ratio between the silver powder and the stress relaxation body (silver powder:stress relaxation body) was 94:6.

(Comparative Example 1)

A composition was obtained by the same method as that in Example 1, except that a stress relaxation body was not used, and the mass ratio (silver powder: stress relaxation body:solvent) was changed to 85:0:15.

(Comparative Example 2)

A composition was obtained by the same method as that in Example 1, except that the type IV silver powder was used. The mass ratio between the silver powder and the stress relaxation body (silver powder:stress relaxation body) was 94:6.

(Comparative Example 3)

A composition was obtained by the same method as that in Example 1, except that the type V silver powder was used. The mass ratio between the silver powder and the stress relaxation body (silver powder:stress relaxation body) was 94:6.

(Comparative Example 4)

A composition was obtained by the same method as that in Example 1, except that the type VI silver powder was used. The mass ratio between the silver powder and the stress relaxation body (silver powder:stress relaxation body) was 94:6.

(Comparative Example 5)

A composition was obtained by the same method as that in Example 1, except that the mass ratio (silver powder:stress relaxation body:solvent) was changed to 84.5:0.5:15. The mass ratio between the silver powder and the stress relaxation body (silver powder:stress relaxation body) was 99.4:0.6.

(Comparative Example 6)

A composition was obtained by the same method as that in Example 1, except that the mass ratio (silver powder:stress relaxation body:solvent) was changed to 45:40:15. The mass ratio between the silver powder and the stress relaxation body (silver powder:stress relaxation body) was 53:47.

(Comparative Example 7)

A composition was obtained by the same method as that in Example 1, except that as a stress relaxation body, a type C stress relaxation body (material: copper, shape: spherical, average particle size: 5 $\mu$m, Young's modulus: 128 GPa, coefficient of thermal expansion: $2 \times 10^{-6}$/K) was used. The mass ratio between the silver powder and the stress relaxation body (silver powder:stress relaxation body) was 94:6.

(Comparative Example 8)

A composition was obtained by the same method as that in Example 1, except that as a stress relaxation body, a type D stress relaxation body (material: polyethylene resin, shape: spherical, average particle size: 5 $\mu$m, Young's modulus: 0.2 GPa, coefficient of thermal expansion: $20 \times 10^{-5}$/K) was used. The mass ratio between the silver powder and the stress relaxation body (silver powder:stress relaxation body) was 94:6.
Table 2 shows the Young's modulus, the coefficient of thermal expansion, the shape, and the material of the stress relaxation bodies used in examples and comparative examples.

[Table 2]

| Type | Solid content | | | | |
|------|---------------|-------|------------------------------|-------------------------|-----------------------------------------|
| | Material | Shape | Average particle size ($\mu$m) | Young's modulus (GPa) | Coefficient of thermal expansion (/K) |
| A | Acrylic resin | Spherical | 10 | 3 | $7 \times 10^{-5}$/K |
| B | Silicone resin | Spherical | 5 | 0.04 | $8 \times 10^{-5}$/K |
| C | Copper | Spherical | 5 | 128 | $2 \times 10^{-6}$/K |
| D | Polyethylene resin | Spherical | 5 | 0.2 | $20 \times 10^{-5}$/K |
| E | Polyimide resin | Spherical | 5 | 4 | $2 \times 10^{-6}$/K |

<Preparation of bonded body>

By using the composition of each of the examples and the comparative examples described above, a bonded body was prepared.

For preparing the bonded body, first, a silver plate was prepared as a substrate. On the silver plate, the composition of Example 1 was printed and molded by using a metal mask (pore size: 3 mm (length) × 3 mm (width) × 50 μm (thickness)).

Then, a silicon chip (size: 2.5 mm (length) × 2.5 mm (width) × 200 μm (thickness)) having a silver-coated surface was placed on the composition and fired by being kept at a temperature of 150°C for 30 minutes in the atmosphere. In this way, a bonding layer was formed between the silver plate and the silicon chip, and a bonded body was obtained.

<Evaluation of bonded body>

The heating-cooling cycle resistance of the bonded body prepared using the composition of each of the examples and the comparative examples was measured. For evaluating the heating-cooling cycle resistance, the bonded body was put into a heating-cooling cycle testing device. Thereafter, the internal temperature of the device was decreased to -40°C from 25°C and kept as it is for 10 minutes, then increased to 180°C and kept as it was for 20 minutes, and then decreased to 25°C. This process is regarded as one cycle, and the heating-cooling cycle resistance was evaluated using a bonding rate obtained after 3,000 cycles. The bonding rate was calculated by Equation (2).

$$(\text{Bonding rate}) = \{(\text{initial bonding area}) - (\text{peeling area})\}/(\text{initial bonding area}) \times 100 \quad (2)$$

The initial bonding area is an area to be bonded that is determined before bonding, in other words, the area of an object to be bonded (silicon chip or the like) that is bonded. In an ultrasonic inspection image, peeling is seen as a white portion in the bonding portion. Therefore, the area of the white portion is regarded as the peeling area. The area of the white portion was determined by performing binarization processing by using image processing software "Image J (developed by National Institutes of Health) and converting the number of pixels in the white portion into the area.

Table 3 shows the makeup of the composition used for preparing the bonded body and the evaluation results of the heating-cooling cycle resistance. Regarding the evaluation shown in Table 3, in a case where the heating-cooling cycle resistance was equal to or higher than 95%, the bonded body was graded "A"; in a case where the heating-cooling cycle resistance was equal to or higher than 85% and less than 95%, the bonded body was graded "B"; in a case where the heating-cooling cycle resistance was equal to or higher than 70% and less than 85%, the bonded body was graded "C"; and in a case where the heating-cooling cycle resistance was less than 70%, the bonded body was graded "D."

[Table 3]

| Composition | Silver powder | | Sintered body of silver powder | Stress relaxation body | | Solvent | | Mass ratio (silver powder: stress relaxation body) | Evaluation of heating-cooling cycle resistance | |
|---|---|---|---|---|---|---|---|---|---|---|
| | Type | Proportion | Young's modulus (GPa) | Type | Proportion | Name | Proportion | | Bonding rate after heating-cooling cycle test | Evaluation |
| Example 1 | I | 80 | 20 | A | 5 | Ethylene glycol | 15 | 94:6 | 97 | A |
| Example 2 | II | 80 | 15 | A | 5 | Ethylene glycol | 15 | 94:6 | 94 | B |
| Example 3 | III | 80 | 25 | A | 5 | Ethylene glycol | 15 | 94:6 | 93 | B |
| Example 4 | I | 84 | 20 | A | 1 | Ethylene glycol | 15 | 99:1 | 92 | B |
| Example 5 | I | 50 | 20 | A | 35 | Ethylene glycol | 15 | 60:40 | 90 | B |
| Example 6 | I | 80 | 20 | B | 5 | Ethylene glycol | 15 | 94:6 | 92 | B |
| Example 7 | I | 80 | 20 | E | 5 | Ethylene glycol | 15 | 94:6 | 88 | B |
| Comparative Example 1 | I | 85 | 20 | N/A | 0 | Ethylene glycol | 15 | - | 80 | c |
| Comparative Example 2 | IV | 80 | 1 | A | 5 | Ethylene glycol | 15 | 94:6 | 45 | D |
| Comparative Example 3 | V | 80 | 1 | A | 5 | Ethylene glycol | 15 | 94:6 | 50 | D |
| Comparative Example 4 | VI | 80 | 1 | A | 5 | Ethylene glycol | 15 | 94:6 | 60 | D |
| Comparative Example 5 | I | 84.5 | 20 | A | 0.5 | Ethylene glycol | 15 | 99.4:0.6 | 65 | C |

(continued)

| Composition | Silver powder | | Sintered body of silver powder | Stress relaxation body | | Solvent | | Mass ratio (silver powder: stress relaxation body) | Evaluation of heating-cooling cycle resistance | |
|---|---|---|---|---|---|---|---|---|---|---|
| | Type | Proportion | Young's modulus (GPa) | Type | Proportion | Name | Proportion | | Bonding rate after heating-cooling cycle test | Evaluation |
| Comparative Example 6 | I | 45 | 20 | A | 40 | Ethylene glycol | 15 | 53:47 | 45 | D |
| Comparative Example 7 | I | 80 | 20 | C | 5 | Ethylene glycol | 15 | 94:6 | 65 | C |
| Comparative Example 8 | I | 80 | 20 | D | 5 | Ethylene glycol | 15 | 94:6 | 20 | D |

As is evident from Table 3, in the bonded body of Comparative Example 1 in which the composition not containing a stress relaxation body was used, because the action of relieving stress caused by the heating-cooling cycle was not performed in the bonding layer, the heating-cooling cycle resistance was poor.

In the bonded body of Comparative Example 2 in which the composition containing the type IV silver powder was used, the heating-cooling cycle resistance was poor for the following reason. In this bonded body, the silver powder was used in which the value of the first peak of the primary particles was less than 20 nm and the value of the second peak was less than 200 nm, the decomposition rate of an organic substance was less than 50% in a case where the silver powder was heated at 150°C, and ethanediol was detected in a case where the silver powder was heated at 100°C. Therefore, the degree of filling of the bonding layer was low, and the sintering properties of the silver powder were poor. As a result, the bonding layer had a structure vulnerable to the stress caused by the heating-cooling cycle.

In the bonded body of Comparative Example 3 in which the composition containing the type V silver powder was used, the heating-cooling cycle resistance was poor for the following reason. In this bonded body, the silver powder was used in which the value of the first peak of the primary particles was greater than 70 nm and the value of the second peak was greater than 500 nm. Therefore, the degree of filling of the bonding layer was low, and the sintering properties of the silver powder were poor. As a result, the bonding layer had a structure vulnerable to the stress caused by the heating-cooling cycle.

In the bonded body of Comparative Example 4 in which the composition containing the type VI silver powder was used, the heating-cooling cycle resistance was poor for the following reason. In this bonded body, the silver powder was used in which the primary particles did not have two peaks, the decomposition rate of an organic substance was less than 50% in a case where the silver powder was heated at 150°C, and pyrrole was detected in a case where the silver powder was heated at 100°C. Therefore, the degree of filling of the bonding layer was low, and the sintering properties of the silver powder were poor. As a result, the bonding layer had a structure vulnerable to the stress caused by the heating-cooling cycle.

In the bonded body of Comparative Example 5 using the composition in which the mass ratio between the silver powder and the stress relaxation body (silver powder:stress relaxation body) was 99.4:0.6, the action of relieving the stress caused by the heating-cooling cycle was weak. Therefore, the heating-cooling cycle resistance was poor.

In the bonded body of Comparative Example 6 using the composition in which the mass ratio between the silver powder and the stress relaxation body (silver powder:stress relaxation body) was 53:47, sintering did not easily occur between silver particles. Therefore, the bonding layer had a structure vulnerable to the stress caused by the heating-cooling cycle, and hence the heating-cooling cycle resistance was poor.

In the bonded body of Comparative Example 7 using the composition containing the stress relaxation body having a Young's modulus higher than a Young's modulus of the sintered body of the silver powder, the stress relieving effect was not sufficiently exerted in the bonding layer, and hence the heating-cooling cycle resistance was poor.

In the bonded body of Comparative Example 8 using the composition containing a stress relaxation body having a coefficient of thermal expansion of equal to or higher than $7 \times 10^{-5}$/K, the volume was greatly increased at the time of heating. Therefore, the internal structure of the bonding layer was easily broken, and hence the heating-cooling cycle resistance was poor.

In contrast, in the assemblies of Examples 1 to 6, the composition was used which contained a silver powder generating gaseous carbon dioxide, acetone vapor, and water vapor in a case where the silver powder is heated at 100°C, a stress relaxation body having a Young's modulus of is 3 GPa or less, and a solvent, in which a particle size distribution of primary particles of the silver powder has a first peak in a range of a particle size of 20 to 70 nm and a second peak in a range of a particle size of 200 to 500 nm, an organic substance in the silver powder is decomposed by 50% by mass or more at 150°C, and a weight ratio between the silver powder and the stress relaxation body is 99:1 to 60:40. The heating-cooling cycle resistance of the bonding layer in this bonded body was excellent.

The heating-cooling cycle resistance of Example 7, in which a stress relaxation body having a Young's modulus of 4 GPa was used, was slightly poorer than that of Examples 1 to 6. However, the heating-cooling cycle resistance of Example 7 was better than that of comparative examples.

Industrial Applicability

The composition of the present invention can be used as, for example, a bonding material at the time of bonding electronic parts and the like onto a substrate.

Reference Signs List

    1: Aqueous silver salt solution

2: Aqueous carboxylate solution
3: Water
4: Silver carboxylate slurry
5: Aqueous reductant solution
11: Bonded body
12: Substrate
13: First metal layer
14: Bonding layer
15: Second metal layer
16: Object to be bonded
17, 18: Interface

**Claims**

1. A composition comprising:

   a silver powder generating gaseous carbon dioxide, acetone vapor, and water vapor in a case where the silver powder is heated at 100°C;
   a stress relaxation body having a Young's modulus lower than a Young's modulus of a sintered body of the silver powder; and
   a solvent,
   wherein a particle size distribution of primary particles of the silver powder has a first peak in a range of a particle size of 20 to 70 nm and a second peak in a range of a particle size of 200 to 500 nm,
   an organic substance in the silver powder is decomposed by 50% by mass or more at 150°C, and
   a mass ratio between the silver powder and the stress relaxation body is 99:1 to 60:40.

2. The composition according to claim 1,
   wherein a Young's modulus of the stress relaxation body is 3 GPa or less.

3. The composition according to claim 1 or 2,
   wherein the stress relaxation body has a spherical shape.

4. The composition according to any one of claims 1 to 3,
   wherein a material of the stress relaxation body is an acrylic resin or a silicone resin.

5. A method of producing a bonded body in which a first member and a second member are bonded to each other through a bonding layer, the method comprising the step of forming the bonding layer by using the composition according to any one of claims 1 to 4.

FIG. 1

FIG. 2

FIG. 3

## INTERNATIONAL SEARCH REPORT

| | International application No. |
|---|---|
| | PCT/JP2016/073821 |

**A. CLASSIFICATION OF SUBJECT MATTER**
*C04B37/02*(2006.01)i, *B22F1/00*(2006.01)i, *B22F7/04*(2006.01)i, *B22F9/00* (2006.01)i, *C09J1/00*(2006.01)i, *C09J11/00*(2006.01)i, *C09J133/00*(2006.01)i, *C09J183/04*(2006.01)i, *C09J201/00*(2006.01)i, *B22F1/02*(2006.01)n
According to International Patent Classification (IPC) or to both national classification and IPC

**B. FIELDS SEARCHED**

Minimum documentation searched (classification system followed by classification symbols)
C04B37/00-37/04, B22F1/00-9/30, C09J1/00-201/10, B23K35/24-34/32

Documentation searched other than minimum documentation to the extent that such documents are included in the fields searched
    Jitsuyo Shinan Koho        1922–1996   Jitsuyo Shinan Toroku Koho   1996–2016
    Kokai Jitsuyo Shinan Koho   1971–2016   Toroku Jitsuyo Shinan Koho   1994–2016

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2008-161907 A (Hitachi, Ltd.), 17 July 2008 (17.07.2008), claims; paragraphs [0030], [0036] to [0059] & US 2008/0173398 A1 claims; paragraphs [0047], [0060] to [0104] & US 2011/0204125 A1 & US 2012/0104618 A1 | 1-5 |
| A | JP 2011-94223 A (Mitsuboshi Belting Ltd.), 12 May 2011 (12.05.2011), claims; paragraphs [0023] to [0082], [0139] to [0146]; fig. 2 (Family: none) | 1-5 |
| A | JP 2012-161818 A (Mitsubishi Materials Corp.), 30 August 2012 (30.08.2012), claims; paragraphs [0016], [0017] (Family: none) | 1-5 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 29 September 2016 (29.09.16) | Date of mailing of the international search report 11 October 2016 (11.10.16) |
|---|---|
| Name and mailing address of the ISA/ Japan Patent Office 3-4-3,Kasumigaseki,Chiyoda-ku, Tokyo 100-8915,Japan | Authorized officer Telephone No. |

Form PCT/ISA/210 (second sheet) (January 2015)

**INTERNATIONAL SEARCH REPORT**

| International application No. |
| --- |
| PCT/JP2016/073821 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2-184578 A  (Hitachi Chemical Co., Ltd.), 19 July 1990 (19.07.1990), claims; page 2, upper right column, line 7 to lower left column, line 15 (Family: none) | 1-5 |
| E,A | WO 2016/129368 A1  (Mitsubishi Materials Corp.), 18 August 2016 (18.08.2016), claims (Family: none) | 1-5 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015177616 A

- JP 2011080147 A